Europäisches Patentamt

(19) European Patent Office

Office européen des brevets

(11) **EP 0 896 428 A2**

(12) **EUROPEAN PATENT APPLICATION**

(43) Date of publication:
**10.02.1999 Bulletin 1999/06**

(51) Int. Cl.$^6$: **H03H 21/00**

(21) Application number: **98113241.8**

(22) Date of filing: **16.07.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **29.07.1997 DE 19732606**

(71) Applicant:
**DEUTSCHE THOMSON-BRANDT GMBH
78048 Villingen-Schwenningen (DE)**

(72) Inventor: **Varga, Imre
81477 München (DE)**

(74) Representative:
**Hartnack, Wolfgang, Dipl.-Ing.
Deutsche Thomson-Brandt GmbH
Licensing & Intellectual Property,
Göttinger Chaussee 76
30453 Hannover (DE)**

(54) **Method for adaptation of FIR filters**

(57)    Adaptive FIR filters are often used in the adaptive digital signal processing of e.g. voice and music signals, LMS or NLMS algorithms frequently being employed for the adaptation. The adaptation properties of the NLMS algorithm are independent of the signal level, in contrast to the LMS algorithm. However, the NLMS algorithm still has the disadvantage that the adaptation properties are not independent of the signal-to-noise ratio of the signal. Instead of using an LMS algorithm, on the one hand, and an NLMS algorithm, on the other hand, the use of a single, third non-linear algorithm over the entire possible range of values is desirable. According to the invention, this is achieved by using, in a generalised LMS algorithm, a step size which is a non-linear function of the signal-to-noise ratio of the input signal.

FIG. 1

EP 0 896 428 A2

Printed by Xerox (UK) Business Services
2.16.7/3.6

**Description**

The invention relates to a method for adaptation of FIR filters.

Prior Art

Adaptive digital filters are used for various purposes in signal processing. FIR (Finite Impulse Response) filters are used the most frequently. Applications for these filters are e.g. in the suppression of echoes and of interfering noise in voice and music signals. Numerous algorithms are available for the adaptation of the FIR filters. The LMS (Least Mean Square) and the NLMS (Normalised LMS) algorithms constitute two important basic algorithms which are used the most in practical applications.

The LMS algorithm for adaptation of the FIR filter coefficients h1, h2, ..., hN has the following form

$$hi(n+1 )= hi(n)+a*e(n)*x(n-i), \qquad i=1,2,...,N$$

where

n: discrete time index,
a: step size = constant,
x(n): sample of the input signal,
d(n): sample of the primary input signal,
y(n): sample of the filter output signal,
e(n): sample of the error signal,

$$e(n) = d(n)-y(n)$$

In the NLMS algorithm, the step size is normalised to the instantaneous value of the power of the input signal Px(n) and thus has the following form

$$hi(n+1) = hi(n)+a*e(n)*x(n-i)/Px(n), \qquad i=1,2,...,N$$

Px(n) can in this case be determined e.g. by the following recursion (first-order low-pass filter)

$$Px(n+1)=(1-q)*Px(n)+q*x^2(n) .$$

Invention

The adaptation properties of the NLMS algorithm are independent of the signal level as a result of the normalisation, in contrast to the LMS algorithm. This affords advantages in those applications in which it is necessary to process non-steady-state signals, such as speech or music. Often in such cases the LMS algorithm is in fact not suitable at all, such as e.g. in the case of compensating for acoustic echoes and noise suppression. However, the NLMS algorithm still has disadvantages if the power of the error signal e(n) is relatively large even though the power Px(n) of the input signal x(n) is small owing to the non-steady-state nature of the said input signal, since the adaptation is disturbed in this case.

The invention is based on the object of specifying a method for adaptation of FIR filters which reduces or entirely prevents adaptation to noises or interference of the adaptation by noises. This object is achieved by means of the method specified in claim 1.

A relatively large power of the error signal e(n) necessitates an increasingly reduced step size in conjunction with an instantaneous power Px(n) of the input signal x(n) that becomes increasingly smaller, in other words LMS-like adaptation. On the other hand, given those values of Px(n) which correspond to the signal activity, NLMS adaptation with a constant step size should be employed. Instead of using an LMS algorithm, on the one hand, and an NLMS algorithm, on the other hand, the use of a single, third algorithm over the entire possible range of values of the input signal power is desirable. In actual fact, the two algorithms can be expressed by a single formula, which reads as follows

$$hi(n+1) = hi(n)+aeff(n)*e(n)*x(n-i)/Px(n), \qquad i = 1,2,...,N$$

In this case, an effective step size aeff has been introduced which is defined as follows:

$$aeff(n) = a0*Px(n) \text{ for the LMS algorithm}$$

$$aeff(n) = a0 = const. \text{ for the NLMS algorithm}$$

This effective step size aeff is thus a linear function of Px(n) for the LMS algorithm and constant for the NLMS algorithm.

In principle, the method according to the invention consists, then, in the fact that an effective step size is chosen in accordance with a non-linear function of the instantaneous signal-to-noise ratio (SNR) of the input signal. Preferably, the non-linear function, in dependence on the signal power, initially has an approximately linear profile and then changes in a continuously variable manner into an approximately constant profile.

The instantaneous SNR changes together with the pulsating of the non-steady-state input signal. Given a small instantaneous SNR, the effective step size is reduced by the adaptation according to the invention, in other words LMS-like adaptation is carried out. This prevents the system from being adapted to the noises and/or the noises from disturbing the adaptation. On the other hand, the effective step size is constant for those instantaneous SNR values which correspond to the signal activity, that is to say that NLMS-like adaptation is effected. As a result, the adaptation properties become largely independent both of the level and of the SNR.

It is advantageous if the step size aeff(n) is calculated in accordance with the formula

$$aeff(n) = a0/(1+(c1/(c2+SNR(n)))^c3),$$

where SNR(n) is the signal-to-noise ratio of the input signal, a0 is the maximum step size and c1, c2, c3 are constant parameters of the function.

It is particularly advantageous to choose the parameter c1 depending on the application and to allocate a value of between 0 and 1 to the parameter c2, and a value of between 1 and 2 to the parameter c3.

The determination of the signal-to-noise ratio of the signal depends on the application. The noise power of the input signal is preferably measured, however, and this can be effected particularly advantageously in signal pauses.

## Drawings

Exemplary embodiments of the invention are described with reference to the figures, in which:

Fig. 1     shows an adaptive filter for linear estimation,
Fig. 2     shows an adaptive filter as an adaptive forward predictor.

## Exemplary embodiments

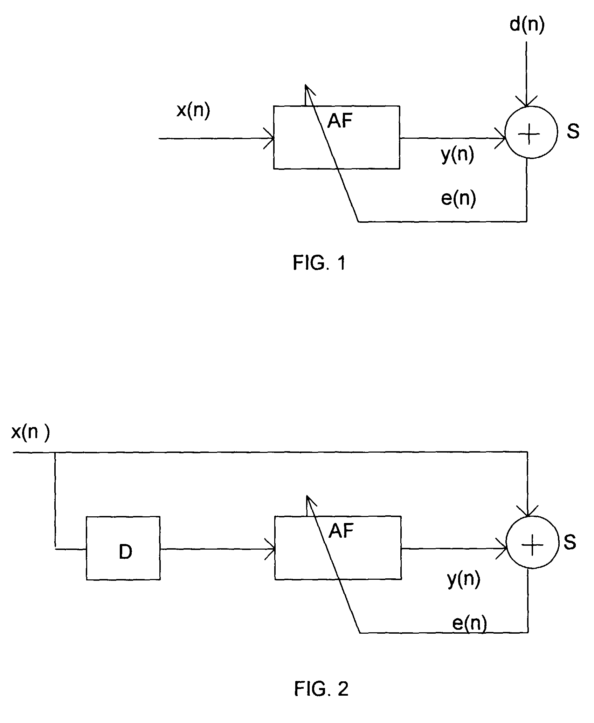

Figure 1 illustrates a filter arrangement for linear estimation of the kind that can be employed for echo suppression, e.g. for the hands-free mode of telephones. From the stochastic input signal x(n) (far-end-speaker) the adaptive FIR filter AF determines an estimate y(n) for the signal d(n) (near-end-speaker + echoes). An optimisation criterion for this is the fact that the square of the error signal e(n) = d(n)-y(n) in the mean value is minimal. In order to determine the error signal, d(n) and y(n) are fed to the summer S. Interference in the signal d(n), e.g. additive noise or near-end-speech, are largely avoided, then, by application of the algorithm according to the invention. A coefficient selection of c2 = 0...1, c3 = 1...2 may be advantageous in this case. The noise power can be determined in this case by measuring the power of the signal d(n) during speech pauses in the signal x(n) by means of low-pass filtering.

Figure 2 illustrates an exemplary embodiment for single-channel noise suppression by means of adaptive forward prediction e.g. for voice input. The adaptive FIR filter AF is fed the signal x(n) only after a delay, preferably of the duration of a sample, by the delay stage D.

The adaptive filter AF then determines an estimate y(n) from the input signal x(n). x(n) and y(n) are fed to the summer S, which determines the error signal e(n) from them. The error signal e(n) is then fed to the adaptive filter for the purpose of adaptation.

Owing to the forward prediction, the adaptation in this case has the following form:

$$hi(n+1) = hi(n)+aeff(n)*e(n)*x(n-i-1)/Px(n), \qquad i = 1,2,...,N$$

Given a suitable selection of parameters c1, c2, c3, an LMS-like adaptation is carried out for a small useful signal level (low signal, pause) and an NLMS-like adaptation is carried out in the case of signal activity, the transition being fluid and determined by c1. Here, too, a selection of c2 = 0..1, c3 = 1...2 is advantageous. For the determination of the SNR, the noise power can be estimated by equating it e.g. to the power of the input signal in signal pauses.

The invention can be used in adaptive digital signal processing, such as e.g. in the event of forward prediction for noise suppression or in the event of compensating for acoustic echoes. In particular, it can be employed in telephones, videophones or the voice control of a very wide variety of consumer electronic devices.

## Claims

1. Method for adaptation of FIR filters, an algorithm being employed for the adaptation of the FIR filter coefficients, in accordance with which algorithm a respective FIR filter coefficient is produced for a specific instant from the sum of an earlier FIR filter coefficient and a product of an effective step size with an error signal (e) and the input signal (x) normalised to the power of the input signal, **characterised** in that an effective step size is chosen in accordance with a non-linear function of the instantaneous signal-to-noise ratio of the input signal.

2. Method according to claim 1, wherein the non-linear function, in dependence on the signal power, initially has an approximately linear profile and then changes in a continuously variable manner into an approximately constant profile.

3. Method according to claim 2, wherein the step size aeff is calculated in accordance with the formula aeff = a0/(1+(c1(c2+SNR))^c3) , where SNR is the signal-to-noise ratio of the input signal, a0 is the maximum step size and c1, c2, c3 are constant parameters of the function.

4. Method according to claim 3, wherein the parameter c1 is chosen depending on the application and the parameter c2 has a value between 0 and 1 and the parameter c3 a value between 1 and 2.

5. Method according to one of claims 1 to 4, wherein the signal-to-noise ratio results from the quotient of the signal power and the noise power and the noise power of the input signal is measured.

6. Method according to claim 5, wherein the noise power is measured in signal pauses.

FIG. 1

FIG. 2